# EUROPÄISCHE PATENTSCHRIFT

(11) **EP 1 661 686 B1**
(45) Veröffentlichungstag und Bekanntmachung des Hinweises auf die Patenterteilung: **12.05.2010**
(21) Anmeldenummer: 05111333.0
(22) Anmeldetag: 25.11.2005
(51) Int. Cl.: B29C 47/02, B29C 47/04, B29C 55/02, B29C 69/02, C08L 83/04, B32B 27/08

(54) **Verfahren zur Herstellung dünner Schichten eines Silikons, dünne Silikonschicht und Verwendung**
Method of manufacturing a thin layer of silicone, thin silicone layer and application
Procédé de fabrication d'une couche mince de silicone, couche mince de silicone et utilisation

(30) Priorität: 26.11.2004 DE 102004057382
(43) Veröffentlichungstag der Anmeldung: 31.05.2006
(73) Patentinhaber: Huhtamaki Forchheim Zweigniederlassung der Huhtamaki Deutschland GmbH & Co. KG, 91301 Forchheim (DE)
(72) Erfinder: Müller, Josef, 91301 Forchheim (DE); Bauer, Michael, Dr., 91301 Forchheim (DE); Günter, Walter, 91301 Forchheim (DE); Stark, Kurt, Dr., 91301 Forchheim (DE)
(74) Vertreter: Hutzelmann, Gerhard

(56) Entgegenhaltungen:
- EP-A1- 1 354 900
- EP-A2- 0 429 911
- WO-A-01/83212
- DE-A1- 10 344 600
- DE-B3- 10 316 521
- US-A- 4 425 176
- US-A1- 2003 008 153
- WACKER-CHEMIE GMBH: "GENIOMER 80" INTERNET PDF ARTICLE, [Online] 17. August 2004 (2004-08-17), XP002412322 Gefunden im Internet: URL:http://www.wacker.com/internet/webcach e/de_DE/PTM/TM/GENIOMER/GENIOMER_80_d.pdf> [gefunden am 2006-12-19]
- FUCHS P: "EXTRUSION UND VERNETZUNG VON FESTEM SILICONKAUTSCHUK" PLASTVERARBEITER, HUETHIG GMBH, HEIDELBERG, DE, Bd. 44, Nr. 6, 1. Juni 1993 (1993-06-01), Seiten 46-48,50, XP000412533 ISSN: 0032-1338

## Beschreibung

Die Erfindung bezieht sich auf ein Verfahren zur Herstellung dünner Schichten eines Silikons, die nach diesem Verfahren hergestellte dünne Silikonschicht und die Verwendung der dünnen Silikonschicht.

Es sind verschiedenste Silikonbeschichtungen bekannt, die sich dünn und sparsam anwenden lassen, dabei jedoch alle den Nachteil aufweisen in einem extra Arbeitsschritt aufwendig auf einen Träger aufgebracht werden zu müssen.

Aus der US 2003/008153 A1 ist beispielsweise ein mehrlagiger thermoplastischer Folienaufbau bekannt, der eine Polyolefinschicht enthält, die mit einem Silikon Additiv versetzt ist.

Aus der Veröffentlichung Geniomer 80 der Wacker Chemie GmbH ist weiterhin ein extrudierbares Silikoncopolymer bekannt.

Aus der WO 01/83212 A1 ist die Coextrusion einer verhältnissmäßig dicken, mit Releaseeigenschaften ausgerüsteten Folienschicht zusammen mit einer Kleberschicht und weiteren Schichten bekannt.

Schlußendlich ist aus der DE 103 44 600 A1 ein Verfahren bekannt, im Blasverfahren einen Verbund aus einer Releaseeigenschaften aufweisenden Folienschicht, und einer Trägerschicht herzustellen, der nur eine Hälfte des Blasrings einnimmt und einer Kleberschicht und der umlaufenden Trägerschicht in der anderen Hälfte bekannt.

Aus allen diesen Veröffentlichungen ist jedoch nicht die Herstellung von dünnen Silikonschichten bekannt.

Aufgabe der Erfindung ist es, ein Verfahren zur Herstellung dünner Schichten eines Silikons vorzuschlagen, welches sich in einem einzigen und einfachen Arbeitsschritt ausführen lässt.

Diese Aufgabe wird erfindungsgemäß dadurch gelöst, daß eine Silikonschicht zumindest mit einer Trägerschicht zusammengeführt wird, wobei eine Deckschicht auf der der Trägerschicht abgewandten Seite der Silikonschicht angeordnet werden kann und wobei zumindest die Silikonschicht aus einem thermoplastischen Silikonelastomer auf dieTrägerschicht aufextrudiert wird oder zumindest die Silikonschicht und die Trägerschicht gemeinsam aus einer Extrusionsdüse extrudiert werden und daß zumindest der Verbund aus Trägerschicht und Silikonschicht gereckt wird und daß wenigstens die Trägerschicht oder die Deckschicht nach der Reckung abgezogen wird.

Hierdurch kann sehr einfach und schnell eine Silikonschicht erzeugt werden.
Durch die Deckschicht wird die Silikonschicht vor Beschädigungen geschützt.
Dadurch kann die Träger- und/oder Deckschicht in einem einzigen Arbeitsschritt zusammen mit der Silikonschicht hergestellt.

Sehr vorteilhaft ist es erfindungsgemäß auch, wenn die Silikonschicht gemeinsam mit der Deckschicht auf die Trägerschicht aufextrudiert wird.

Eine weitere sehr vorteilhafte Ausgestaltung der Erfindung liegt auch darin, daß zwischen Trägerschicht und Silikonschicht ein Haftvermittler eingebracht wird.

Ebenfalls als sehr vorteilhaft hat es sich erwiesen, wenn zwischen der Deckschicht und der Silikonschicht ein Haftvermittler eingebracht wird.

Dadurch ist eine gute Verbindung zwischen den Schichten sichergestellt.

Äußerst vorteilhaft ist es, wenn der Haftvermittler zusammen mit der Silikonschicht extrudiert wird.

Ebenfalls äußerst vorteilhaft ist es, wenn der Haftvermittler zusammen mit der Deckschicht oder der Trägerschicht extrudiert wird.

Eine weitere sehr vorteilhafte Ausgestaltung liegt auch dann vor, wenn der Haftvermittler auf die bereits extrudierte Silikonschicht aufgebracht wird.

Ebenfalls sehr vorteilhaft ist es, wenn der Haftvermittler auf die bereits extrudierte Deckschicht bzw. Trägerschicht aufgebracht wird.

Hierdurch lässt sich ein mehrschichtiger Verbund in nur einem Arbeitsschritt kostengünstig herstellen.

Erfindungsgemäß ist es auch sehr vorteilhaft, wenn die fertige Silikonschicht aufgewickelt wird.

Hierdurch kann die fertige Silikonschicht besonders leicht gelagert und transportiert werden.

Dabei hat es sich als sehr vorteilhaft erwiesen, wenn zwischen zwei Lagen der Silikonschicht eine Deck- oder Trägerschicht vorgesehen ist.

Dadurch wird ein Anhaften zweier Lagen der Silikonschicht aneinander vermieden.

Ebenfalls sehr vorteilhaft ist es erfindungegmäß, wenn als Trägerschicht und/oder Deckschicht ein thermoplastisches Material vorgesehen wird.

Ein thermoplastisches Silikon-Elastomer lässt sich besonders gut extrudieren.

Ebenfalls sehr vorteilhaft ist es, wenn als thermoplastisches Material Polyethylen, insbesondere LDPE oder LLDPE vorgesehen wird.

Gemäß einer weiteren Ausgestaltung der Erfindung hat es sich auch als sehr vorteilhaft erwiesen, wenn als thermoplastisches Material Polypropylen, insbesondere Polypropylen-Homopolymere und Polypropylen-Copolymere vorgesehen wird.

Auch sehr vorteilhaft ist es, wenn ein Blend aus verschiedenen Materialien als Trägerschicht und/oder Deckschicht vorgesehen wird.

Thermoplastische Materialien eignen sich aufgrund ihrer Eigenschaften besonders gut als Trägerschicht und/oder Deckschicht.

Eine sehr vorteilhafte Weiterbildung der Erfindung liegt auch dann vor, wenn als Haftvermittler EthylenAcrylat Copolymere, EthylenVinylacetat Copolymere, Säure Copolymere, Polymere mit Säureanhydrid-Funktionen, insbesondere mit ungesättigten Säureanhydriden versehenes Polyethylen und Polypropylen, Polymere und Copolymerisate die Hydroxylgruppen enthalten, insbesondere Polyvinylalkohole, ethylenhaltige Polyvinylakohole, Hydroxyethylacrylat oder Ionomere eingesetzt werden.

Dabei ist es ebenfalls sehr vorteilhaft, wenn die Haftvermittler aus Blends oder Batches bestehen, die wenigstens zum Teil EthylenAcrylat Copolymere, EthylenVinylacetat Copolymere, Säure Copolymere, Polymere mit Säureanhydrid-Funktionen, insbesondere mit ungesättigten Säureanhydriden versehenes Polyethylen und Polypropylen, Polymere und Copolymerisate die Hydroxylgruppen enthalten, insbesondere Polyvinylalkohole, ethylenhaltige Polyvinylakohole, Hydroxyethylacrylat und/oder Ionomere enthalten.

Weiterhin hat es sich als sehr vorteilhaft erwiesen, wenn als Haftvermittler EthylenVinylacetat Copolymere vorgesehen sind, wobei die Copolymeranteile vorzugsweise größer als 5% sind.

Durch diese Haftvermittler lässt sich der Zusammenhalt zwischen der Silikonschicht und den anderen Schichten in weiten Grenzen einstellen.

Gemäß einer weiteren Ausgestaltung der Erfindung hat es sich als sehr vorteilhaft erwiesen, wenn die Trägerschicht vor dem Recken eine Dicke zwischen 5 und 3000 µm, insbesondere zwischen 10 und 500 µm, vorzugsweise zwischen 10 und 200 µm aufweist.

Es hat sich erfindungsgemäß auch als sehr vorteilhaft erwiesen, wenn die Deckschicht vor dem Recken eine Dicke zwischen 5 und 3000 µm, insbesondere zwischen zwischen 10 und 500 µm, vorzugsweise zwischen 10 und 200 µm aufweist.

Gemäß einer Weiterbildung der Erfindung ist auch eine nach dem erfindungsgemäßen Verfahren hergestellte dünne extrudierte Silikonschicht sehr vorteilhaft.

Ebenfalls äußerst vorteilhaft ist es, wenn das thermoplastische Silikon-Elastomer eine Dicke von 0,1 bis 3000 µm, insbesondere zwischen 1 und 70, insbesondere zwischen von 1 bis 30 µm, ganz besonders zwischen 5 und 20 µm aufweist.

Eine weitere sehr vorteilhafte Ausgestaltung der Erfindung ist auch darin zu sehen, daß das thermoplastische Silikon-Elastomer vorzugsweise einen Anteil an einer organischen Silikonkomponente aufweist, der größer 90% ist.

Die Silikonkomponente ist im wesentlichen für die Releaseeigenschaften des Silikon-Elastomers verantwortlich. Durch den großen Anteil der Silikonkomponente werden gute Releaseeigenschaften sichergestellt.

Es hat sich desweiteren als sehr vorteilhaft erwiesen, wenn das Silikon-Elastomer eine Trennkraft gegenüber Klebstoffen, insbesondere gegenüber Haftklebstofffen zwischen 1 und 700 cN/cm, vorzugsweise zwischen 5 und 100 cN/cm aufweist.

Damit ist ein weiter Einsatzbereich des Silikon-Elastomers als Releasematerial sichergestellt.

Sehr vorteilhaft ist es auch, wenn das Silikon-Elastomer eine Schmelzviskosität zwischen 10000 und 100000, insbesondere zwischen 35000 und 45000 Pas aufweist.

Hierdurch lässt sich das Silikon-Elastomer sehr gut extrudieren.

Erfindungsgemäß hat es sich auch als sehr vorteilhaft erwiesen, wenn das Silikon-Elastomer eine Shore Härte zwischen 10 und 100, insbesondere zwischen 50 und 60 aufweist.

Eine weitere sehr vorteilhafte Ausgestaltung der Erfindung liegt auch darin, daß die Klebkraftminderung nach FINAT 11 eines Haftklebstoffes durch das Silikonelastomer < 30%, insbesondere < 10% ist.

Damit wird die Klebkraft eines Haftklebstoffes bei Lagerung möglichst wenig beeinflusst.

Es hat sich auch als sehr vorteilhaft erwiesen, wenn die Dicke der Silikon-Elastomer-Schicht nach dem Recken zwischen 1 und 400 µm, insbesondere zwischen 1 und 50 µm, vorzugsweise zwischen 1 und 5 µm beträgt.

Eine erfindungsgemäß sehr vorteilhafte Verwendung eines dünnen Silikons liegt auch darin, daß ein Verbund aus Silikonschicht und Deckschicht und/oder Trägerschicht zur Herstellung, Abdeckung oder Auskleidung eines mit einer Silikonschicht versehenen Gegenstandes, insbesondere einer Verpackung oder eines Gefäßes eingesetzt wird.

Hierdurch wird beispielsweise die Innenseite des Gefäßes zum Beispiel zur Aufnahme von Haftklebstoffen vorbereitet.

Dabei hat es sich als sehr vorteilhaft erwiesen, wenn die Silikonschicht auf ein Basismaterial aufkaschiert wird, wobei die Träger- oder Deckschicht vom Basismaterial wegweist, und dann zusammen mit dem Basismaterial zu einem Behälter tiefgezogen wird.

Ebenfalls als sehr vorteilhaft hat es sich erwiesen, wenn der Verbund aus Trägerschicht, Silikonschicht und Deckschicht gemeinsam auf ein Basismaterial aufgebracht wird und dann zusammen mit dem Basismaterial zu einem Behälter tiefgezogen wird.

Dabei ist es sehr vorteilhaft, wenn der Verbund aus Trägerschicht, Silikonschicht und Deckschicht gemeinsam zu einem Behälter tiefgezogen wird.

Als äußerst vorteilhaft hat es sich erwiesen, wenn die Trägerschicht oder die Deckschicht nach Fertigstellung des Behälters abgezogen wird.

Durch die Verbindung der Silikonschicht mit der Trägerschicht wird ein Reißen der Silikonschicht beim Tiefziehen verhindert. Dieser Effekt wird noch durch die Deckschicht verstärkt. Zusätzlich verhindert die Deckschicht etwaige Beschädigungen der Silikonschicht bei der Herstellung und beim Transport der ungefüllten Behälter.

Gemäß einer weiteren Ausgestaltung der Erfindung ist es auch sehr vorteilhaft, wenn die Silikonschicht eine hochtransparente, vorzugsweise witterungsstabile Schutzschicht für den Gegenstand bildet.

Ebenfalls sehr vorteilhaft ist es, wenn die Silikonschicht eine schmutzabweisende Schutzschicht für den Gegenstand bildet.

Hierdurch kann ein Gegenstand oder dergleichen vor vielen Umwelteinflüssen geschützt werden.
Eine weitere sehr vorteilhafte Ausgestaltung der Erfindung liegt auch darin, daß die Silikonschicht als Schutzschicht auf insbesondere glatten Flächen verwendet wird.

Dabei ist es sehr vorteilhaft, wenn die Silikonschicht auf insbesondere glatten Flächen durch Adhäsion gehalten wird.

Damit werden Anwendungen der Silikonschicht als abziehbare und/oder auswechselbare Schutzschichten möglich.

Es hat sich gemäß einer weiteren Ausgestaltung der Erfindung auch als vorteilhaft erwiesen, wenn die Silikonschicht als Trennschicht zu beliebigen Flächengebilden eingesetzt wird.

Hierdurch werden zum Beispiel Anwendungen der Silikonschicht eventuell in Verbindung mit weiteren Schichten denkbar, die eine Trennung mehrerer Lagen eines Gegenstandes zur Aufgabe haben.

Äußerst vorteilhaft ist es gemäß einer Fortbildung der Erfindung auch, daß die Silikonschicht in Hygieneanwendungen Verwendung findet, insbesondere in Hygieneverpackungen oder dergleichen.

Damit wird eine sehr einfache Herstellung solcher Verpackungen oder dergleichen sichergestellt.

Eine weitere erfindungsgemäß sehr vorteilhafte Anwendung der Erfindung liegt auch dann vor, wenn die Silikonschicht als Zwischenschicht zwischen mehreren Lagen einer Fensterscheibe eingesetzt wird.

Hiermit können unter anderm Sicherheitsscheiben mit einer Zwischenschicht mit der erfindungsgemäßen Silikonschicht hergestellt werden.

Es hat sich auch als äußerst vorteilhaft erwiesen, wenn die Silikonschicht zusammen mit weiteren Schichten verbunden hergestellt wird und zusammen mit diesen Schichten eine Fensterscheibe oder dergleichen bildet.

Dadurch wird auch die Herstellung von Scheiben, Ersatzscheiben oder ähnlichem in einem einzigen Arbeitsschritt ermöglicht.

Im folgenden wird die Erfindung anhand mehrerer Ausführungsbeispiele veranschaulicht.

### Dabei zeigen:

- Fig. 1: ein dreischichtiges Coextrudat,
- Fig. 2: ein funfschichtiges Coextrudat, und

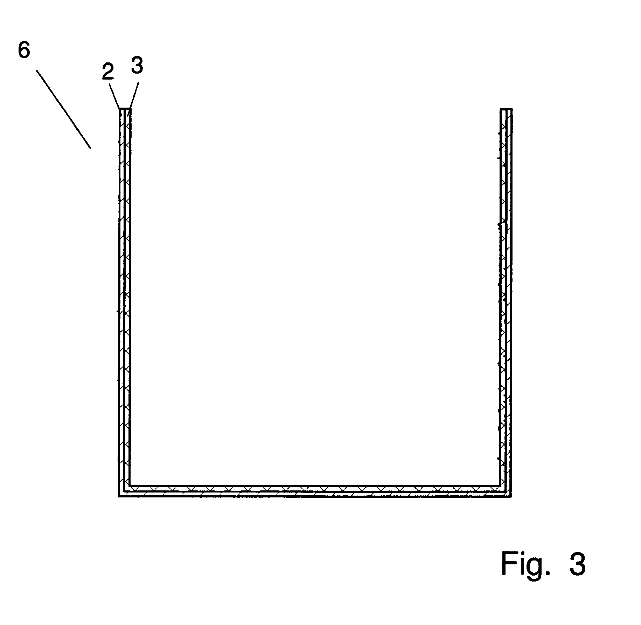

- Fig. 3: einen tiefgezogenen Behälter, der einen Teil des Coextrudates enthält.

In einem ersten Beispiel wird aus einer Düse ein dreischichtiges Coextrudat 1 extrudiert. Dieses Coextrudat 1 besteht aus einer Trägerschicht 2 aus einem thermoplastischen Material, einer darauf folgenden Silikonschicht 3 aus einem thermoplastisches Silikon-Elastomer. Auf das Silikon-Elastomer folgt eine Deckschicht 4 ebenfalls aus einem thermoplastischen Material.

Das thermoplastische Material kann ein Polyethylen, z.B. ein LDPE oder ein LLDPE, ein Polypropylen oder dergleichen oder ein Blend verschiedener Materialien sein.

Nach der Extrusion kann der Verbund in Längs- und/oder Querrichtung gereckt werden, wodurch sich einerseits die Festigkeitseigenschaften der einzelnen Schichten verbessern und andererseits die Schichtdicken reduziert werden. Bei der Extrusion kann die Trägerschicht 2 und die Deckschicht 4 jeweils eine Dicke zwischen 10 und 500 µm aufweisen. Die Silikonschicht 3 kann eine Dicke im Bereich zwischen 5 und 30 µm aufweisen. Durch das Recken werden diese Dicken signifikant reduziert, wodurch derzeit Silikonschichten 3 in einer Dicke von 1 bis 5 µm erreichbar sind. Mit einer weiter verfeinerten Abstimmung der Reckmethoden sind auch Silikonschichten 3 in einer Dicke bis 0, 1µm erreichbar.

Die Silikonschicht 3 wird beim Reckvorgang durch die Trägerschicht 2 und die Deckschicht 4 stabilisiert. Besonders wird verhindert, daß die Silikonschicht 3 Risse bildet oder völlig auseinander reißt.

Nach dem Reckvorgang kann die Deckschicht 4 oder die Trägerschicht 2 abgezogen werden.

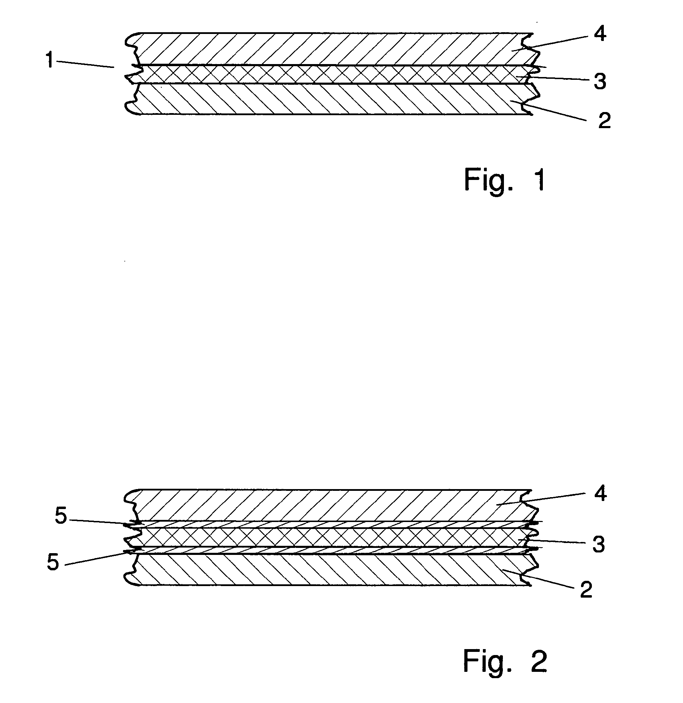

Es ist aber auch denkbar, daß zwischen der Silikonschicht 3 und der Trägerschicht 2 bzw. der Deckschicht 4 ein Haftvermittler 5 vorgesehen ist, wie dies in Fig. 2 dargestellt ist.

Durch den Haftvermittler 5 kann die Adhäsionskraft zwischen den einzelnen Schichten in weiten Bereichen eingestellt werden. Als Haftvermittler bieten sich vor allem EthylenAcrylat Copolymere, EthylenVinylacetat, Säure Copolymere, Polymere mit Säureanhydrid-Funktionen, insbesondere mit ungesättigten Säureanhydriden versehenes Polyethylen und Polypropylen, Polymere und Copolymerisate die Hydroxylgruppen enthalten, insbesondere Polyvinylalkohole, ethylenhaltige Polyvinylakohole, Hydroxyethylacrylat, Ionomere oder dergleichen an. Diese Haftvermittler können zudem in Form von Blends oder Batches mit anderen Stoffen vorgesehen sein.

Die Säureanhydrid- und/oder Hydroxylgruppen-funktionalisierten Haftvermittler können durch Copolymerisation von insbesondere organischen Monomeren mit ungesättigten Säureanhydriden bzw. Hydroxylgruppen-haltigen Monomeren, wie zum Beispiel Maleinsäureanhydrid, Hydroxylethylacrylat, Hydroxypropylacrylat oder dergleiche, oder durch Propfung von Polymeren mit ungesättigten Säureanhydriden bzw. Hydroxylgruppen-haltigen Monomeren erzeugt werden.

Es ist aber auch denkbar, daß wenigstens die Trägerschicht 2 oder die Deckschicht 3 als Zulaufbahn vorgesehen ist und direkt nach der Extrusion zugeführt wird.

Ein solcher Verbund ist besonders zur Herstellung und Auskleidung von mit klebrigen Substanzen zu befüllenden Behältern geeignet.

So ist es denkbar, daß das Coextrudat 1 als Einschlagverpackung für Blöcke oder dergleichen von zum Beispiel Haftklebstoffen genutzt wird. Es ist aber auch denkbar, daß das Coextrudat 1 zu einem Behälter 6 tiefgezogen wird. Es kann aber auch sein, daß das Coextrudat 1 auf einen weiteren Träger aufgebracht wird, der dann zusammen mit dem Coextrudat 1 zu einer Verpackung zum Beispiel durch Tiefziehen geformt wird.

Beim Tiefziehen wird das Coextrudat 1 gereckt.

Denkbar ist es auch, daß nur ein Teil des Coextrudates 1 für den Tiefzieh- bzw. Verpackungsvorgang genutzt wird.

So kann zum Beispiel die Träger- 2 oder Deckschicht 4 des Coextrudates 1 abgezogen worden sein, bevor der Rest des Coextrudates zum Beispiel auf eine Dickschichtfolie aus Polypropylen aufgebracht wird. Anschließend wird diese Dickschichtfolie zusammen mit der Silikonschicht 3 tiefgezogen. Die verbliebene Deck- 4 oder Trägerschicht 2 verhindert dabei ebenso wie beim Recken ein ungewolltes Aufplatzen der Silikonschicht 3. Nach dem Tiefziehvorgang oder kurz vor Befüllung des Behälters mit dem zu verpackenden Gut kann dann die verbliebene Deck- 4 oder Trägerschicht 2 abgezogen werden. Während des Transportes des Behälters werden so Beschädigungen der Silikonschicht 3 verhindert.

Es ist aber auch denkbar, daß das Coextrudat 1 auch für andere Einsatzzwecke Verwendung findet. So kann zum Beispiel das Coextrudat 1 Grundstock für die Herstellung von Etiketten, Hygieneverpackungen, Schutzfolien gegen Umwelteinflüsse, abziehbare Schutzfolien, Fensterzwischenschichten bei Sicherheitsglas, Fensterscheiben oder dergleichen sein. Es werden für diese Anwendungen benötigte zusätzliche Schichten entweder nachträglich dem Coextrudat 1 zugeführt oder gleich zusammen mit den Schichten des Coextrudates 1 extrudiert.

Besonders bei der Verwendung des Coextrudats 1 für Hygieneverpackungen ist es denkbar, daß die Trägerfolie mit einem Füllstoff wie zum Beispiel Kreide versehen ist.

Es ist auch denkbar, daß zum Beispiel ein im Blasverfahren hergestelltes Coextrudat 1 mit einer Dicke der Trägerschicht 2 zwischen 100 und 300 µm, einer Haftvermittlerschicht mit einer Dicke zwischen 10 und 20 µm und einer extrudierten Silikonschicht mit einer Dicke zwischen 8 und 15 µm derart gereckt wird, daß die Dicke der Trägerfolie nach dem Recken zwischen 30 und 70 µm beträgt. Dabei wird die Silikonschicht auf eine Dicke von bis zu 0, 1 µm reduziert. Gleichzeitig wird die Steifigkeit und Festigkeit des Verbundes erheblich erhöht.

## Patentansprüche

1. Verfahren zur Herstellung dünner Schichten eines extrudierbaren Silikons, **dadurch gekennzeichnet, daß** eine Silikonschicht (3) zumindest mit einer Trägerschicht (2) zusammengeführt wird, wobei eine Deckschicht (4) auf der der Trägerschicht (2) abgewandten Seite der Silikonschicht (3) angeordnet werden kann und wobei zumindest die Silikonschicht (3) aus einem thermoplastischen Silikonelastomer auf die Trägerschicht (2) aufextrudiert wird oder zumindest die Silikonschicht (3) und die Trägerschicht (2) gemeinsam aus einer Extrusionsdüse extrudiert werden und daß zumindest der Verbund aus Trägerschicht (2) und Silikonschicht (3) gereckt wird und daß wenigstens die Trägerschicht (2) oder die Deckschicht (4) nach der Reckung abgezogen wird.

2. Verfahren nach Anspruch 1, **dadurch gekennzeichnet, daß** die Silikonschicht (3) gemeinsam mit der Deckschicht (4) auf die Trägerschicht (2) aufextrudiert wird.

3. Verfahren nach Anspruch 1 oder 2, **dadurch gekennzeichnet, daß** zwischen Trägerschicht (2) und Silikonschicht (3) ein Haftvermittler (5) eingebracht wird.

4. Verfahren nach Anspruch 1, 2 oder 3, **dadurch gekennzeichnet, daß** zwischen der Deckschicht (4) und der Silikonschicht (3) ein Haftvermittler (5) eingebracht wird.

5. Verfahren nach Anspruch 3 oder 4, **dadurch gekennzeichnet, daß** der Haftvermittler (5) zusammen mit der Silikonschicht (3) extrudiert wird.

6. Verfahren nach Anspruch 3 oder 4, **dadurch gekennzeichnet, daß** der Haftvermittler (5) zusammen mit der Deckschicht (4) oder der Trägerschicht (2) extrudiert wird.

7. Verfahren nach Anspruch 3 oder 4, **dadurch gekennzeichnet, daß** der Haftvermittler (5) auf die bereits extrudierte Silikonschicht (3) aufgebracht wird.

8. Verfahren nach Anspruch 3 oder 4, **dadurch gekennzeichnet, daß** der Haftvermittler (5) auf die bereits extrudierte Deckschicht (4) bzw. Trägerschicht (2) aufgebracht wird.

9. Verfahren nach einem der vorangehenden Ansprüche, **dadurch gekennzeichnet, daß** die fertige Silikonschicht (3) aufgewickelt wird.

10. Verfahren nach Anspruch 9, **dadurch gekennzeichnet, daß** zwischen zwei Lagen der Silikonschicht (3) eine Deck- (4) oder Trägerschicht (2) vorgesehen wird.

11. Verfahren nach einem der vorangehenden Ansprüche, **dadurch gekennzeichnet, daß** als Trägerschicht (2) und/oder Deckschicht (4) ein thermoplastisches Material vorgesehen wird.

12. Verfahren nach Anspruch 11, **dadurch gekennzeichnet, daß** als thermoplastisches Material Polyethylen, insbesondere LDPE oder LLDPE vorgesehen wird.

13. Verfahren nach Anspruch 11 oder 12, **dadurch gekennzeichnet, daß** als thermoplastisches Material Polypropylen, insbesondere Polypropylen-Homopolymere und Polypropylen-Copolymere vorgesehen wird.

14. Verfahren nach einem der Ansprüche 11 bis 13, **dadurch gekennzeichnet, daß** ein Blend aus verschiedenen Materialien als Trägerschicht (2) und/oder Deckschicht (4) vorgesehen wird.

15. Verfahren nach einem der Ansprüche 11 bis 14, **dadurch gekennzeichnet, daß** als Haftvermittler (5) EthylenAcrylat Copolymere, EthylenVinylacetat Copolymere, Säure Copolymere, Polymere mit Säureanhydrid-Funktionen, insbesondere mit ungesättigten Säureanhydriden versehenes Polyethylen und Polypropylen, Polymere und Copolymerisate die Hydroxylgruppen enthalten, insbesondere Polyvinylalkohole, ethylenhaltige Polyvinylalkohole and Hydroxyethylacrylat oder Ionomere eingesetzt werden.

16. Verfahren nach Anspruch 15, **dadurch gekennzeichnet, daß** die Haftvermittler (5) aus Blends oder Batches bestehen, die wenigstens zum Teil EthylenAcrylat Copolymere, EthylenVinylacetat Copolymere, Säure Copolymere, Polymere mit Säureanhydrid-Funktionen, insbesondere mit ungesättigten Säureanhydriden versehenes Polyethylen und Polypropylen, Polymere und Copolymerisate die Hydroxylgruppen enthalten, insbesondere Polyvinylalkohole, ethylenhaltige Polyvinylalkohole, Hydroxyethylacrylat und/oder Ionomere enthalten.

17. Verfahren nach Anspruch 15 oder 16, **dadurch gekennzeichnet, daß** als Haftvermittler (5) EthylenVinylacetat Copolymere vorgesehen werden, wobei die Copolymeranteile vorzugsweise größer als 5% sind.

18. Verfahren nach einem der Ansprüche 11 bis 17, **dadurch gekennzeichnet, daß** die Trägerschicht (2) vor dem Recken eine Dicke zwischen 5 und 3000 µm, insbesondere zwischen 10 und 500 µm, vorzugsweise zwischen 10 und 200 µm aufweist.

19. Verfahren nach einem der Ansprüche 11 bis 18, **dadurch gekennzeichnet, daß** die Deckschicht (4) vor dem Recken eine Dicke zwischen 5 und 3000 µm insbesondere zwischen 10 und 500 µm, vorzugsweise zwischen 10 und 200 µm aufweist.

20. Dünne extrudierte Silikonschicht, hergestellt nach einem Verfahren gemäß den Ansprüchen 1 bis 19.

21. Dünne Silikonschicht nach Anspruch 20, **dadurch gekennzeichnet, daß** die Silikonschicht (3) aus dem thermoplastischen Silikonelastomer eine Dicke von 0,1 bis 3000 µm, vorzugsweise von 1 bis 70, insbesondere zwischen 1 bis 30 µm, ganz besonders zwischen 5 und 20 µm aufweist.

22. Dünne Silikonschicht nach Anspruch 20 oder 21, **dadurch gekennzeichnet, daß** das thermoplastische Silikonelastomer vorzugsweise einen Anteil an einer organischen Silikonkomponente aufweist, der größer 90% ist.

23. Dünne Silikonschicht nach Anspruch 20, 21 oder 22, **dadurch gekennzeichnet, daß** das Silikonelastomer eine Trennkraft gegenüber Klebstoffen, insbesondere gegenüber Haftklebstoffen zwischen 1 und 700 cN/cm, vorzugsweise zwischen 5 und 100 cN/cm aufweist.

24. Dünne Silikonschicht nach einem der Ansprüche 20 bis 23, **dadurch gekennzeichnet, daß** das Silikonelastomer eine Schmelzviskosität zwischen 10000 und 100000, insbesondere zwischen 35000 und 45000 Pas aufweist.

25. Dünne Silikonschicht nach einem der Ansprüche 20 bis 24, **dadurch gekennzeichnet, daß** das Silikonelastomer eine Shore Härte zwischen 10 und 100, insbesondere zwischen 50 und 60 aufweist.

26. Dünne Silikonschicht nach einem der Ansprüche 20 bis 25, **dadurch gekennzeichnet, daß** die Klebkraftminderung nach FINAT 11 eines Haftklebstoffes durch das Silikonelastomer < 30%, insbesondere < 10% ist.

27. Dünne Silikonschicht nach einem der Ansprüche 20 bis 26, **dadurch gekennzeichnet, daß** die Dicke der Silikonelastomer-Schicht (3) nach dem Recken zwischen 0,1 und 400 µm, insbesondere zwischen 0,1 und 50 µm, vorzugsweise zwischen 0,1 und 5 µm beträgt.

28. Verwendung eines dünnen extrudierten thermoplastischen Silikonelastomers in Form einer Silikonschicht, nach einem der Ansprüche 20 bis 27, hergestellt nach einem Verfahren nach einem der Ansprüche 1 bis 19, **dadurch gekennzeichnet, daß** ein Verbund aus Silikonschicht (3) und Deckschicht (4) und/oder Trägerschicht (2) zur Herstellung, Abdeckung oder Auskleidung eines mit einer Silikonschicht (3) zu versehenen Gegenstandes, insbesondere einer Verpackung oder eines Gefäßes (6) eingesetzt wird.

29. Verwendung nach Anspruch 28, **dadurch gekennzeichnet, daß** die Silikonschicht (3) auf ein Basismaterial aufkaschiert wird, wobei die Träger- (2) oder Deckschicht (4) vom Basismaterial wegweist, und dann zusammen mit dem Basismaterial zu einem Behälter (6) tiefgezogen wird.

30. Verwendung nach Anspruch 28, **dadurch gekennzeichnet, daß** der Verbund (1) aus Trägerschicht (2), Silikonschicht (3) und Deckschicht (4) gemeinsam auf ein Basismaterial aufgebracht wird und dann zusammen mit dem Basismaterial zu einem Behälter (6) tiefgezogen wird.

31. Verwendung nach Anspruch 28, **dadurch gekennzeichnet, daß** der Verbund (1) aus Trägerschicht (2), Silikonschicht (3) und Deckschicht (4) gemeinsam zu einem Behälter (6) tiefgezogen wird.

32. Verwendung nach Anspruch 29, 30 oder 31, **dadurch gekennzeichnet, daß** die Trägerschicht (2) oder die Deckschicht (4) nach Fertigstellung des Behälters (6) abgezogen wird.

33. Verwendung nach einem der Ansprüche 28 bis 32, **dadurch gekennzeichnet, daß** die Silikonschicht (3) eine hochtransparente, vorzugsweise witterungsstabile Schutzschicht für den Gegenstand bildet.

34. Verwendung nach einem der Ansprüche 28 bis 33, **dadurch gekennzeichnet, daß** die Silikonschicht (3) eine schmutzabweisende Schutzschicht für den Gegenstand bildet.

35. Verwendung nach einem der Ansprüche 28 bis 34, **dadurch gekennzeichnet, daß** die Silikonschicht (3) als Schutzschicht auf insbesondere glatten Flächen verwendet wird.

36. Verwendung nach Anspruch 35, **dadurch gekennzeichnet, daß** die Silikonschicht (3) auf insbesondere glatten Flächen durch Adhäsion gehalten wird.

37. Verwendung nach einem der Ansprüche 28 bis 36, **dadurch gekennzeichnet, daß** die Silikonschicht (3) als Trennschicht zu beliebigen Flächengebilden eingesetzt wird.

38. Verwendung nach einem der Ansprüche 28 bis 37, **dadurch gekennzeichnet, daß** die Silikonschicht (3) in Hygieneanwendungen Verwendung findet, insbesondere in Hygieneverpackungen oder dergleichen.

39. Verwendung nach einem der Ansprüche 28 bis 38, **dadurch gekennzeichnet, daß** die Silikonschicht (3) als Zwischenschicht zwischen mehreren Lagen einer Fensterscheibe eingesetzt wird.

40. Verwendung nach einem der Ansprüche 28 bis 39, **dadurch gekennzeichnet, daß** die Silikonschicht (3) zusammen mit weiteren Schichten verbunden hergestellt wird und zusammen mit diesen Schichten eine Fensterscheibe oder dergleichen bildet.

## Claims

1. Method of producing thin layers of an extrudable silicon, **characterised in that** a silicon layer (3) is brought together with at least a carrier layer (2), wherein a cover layer (4) can be arranged on the side of the silicon layer (3) remote from the carrier layer (2) and wherein at least the silicon layer (3) consists of a thermosplastic silicon elastomer onto which the carrier layer (2) is extruded or at least the silicon layer (3) and the carrier layer (2) are extruded in common from an extrusion nozzle, and that at least the composite of carrier layer (2) and silicon layer (3) is stretched and that at least the carrier layer (2) or the cover layer (4) is pulled off after the stretching.

2. Method according to claim 1, **characterised in that** the silicon layer (3) is extruded together with the cover layer (4) onto the carrier layer (2).

3. Method according to claim 1 or 2, **characterised in that** an adhesive agent (5) is introduced between carrier layer (2) and silicon layer (3).

4. Method according to claim 1, 2 or 3, **characterised in that** an adhesive agent (5) is introduced between the cover layer (4) and the silicon layer (3).

5. Method according to claim 3 or 4, **characterised in that** the adhesive agent (5) is extruded together with the silicon layer (3).

6. Method according to claim 3 or 4, **characterised in that** the adhesive agent (5) is extruded together with the cover layer (4) or the carrier layer (2).

7. Method according to claim 3 or 4, **characterised in that** the adhesive agent (5) is applied to the already extruded silicon layer (3).

8. Method according to claim 3 or 4, **characterised in that** the adhesive agent (5) is applied to the already-extruded cover layer (4) or carrier layer (2).

9. Method according to any one of the preceding claims, **characterised in that** the finished silicon layer (3) is wound up.

10. Method according to claim 9, **characterised in that** a cover layer (4) or carrier layer (2) is provided between two plies of the silicon layer (3).

11. Method according to any one of the preceding claims, **characterised in that** a thermoplastic material is provided as carrier layer (2) and/or cover layer (4).

12. Method according to claim 11, **characterised in that** polyethylene, particularly LDPE or LLDPE, is provided as thermoplastic material.

13. Method according to claim 11 or 12, **characterised in that** polypropylene, particularly polypropylene homopolymers and polypropylene copolymers, is provided as thermoplastic material.

14. Method according to any one of claims 11 to 13, **characterised in that** a blend of different materials is provided as carrier layer (2) and/or cover layer (4).

15. Method according to any one of claims 11 to 14, **characterised in that** ethylene acrylate copolymers, ethylene vinylacetate copolymers, acid copolymers, polymers with acid anhydride functions, particularly polyethylene and polypropylene provided with unsaturated acid anhydrides, polymers and copolymerisates which contain hydroxyl groups, particularly polyvinylalcohols, polyvinylalcohols containing ethylene and hydroxyethylacrylate or ionomers are used.

16. Method according to claim 15, **characterised in that** the adhesive agents (5) consist of blends or batches which contain at least in part ethylene acrylate copolymers, ethylene vinylacetate copolymers, acid copolymers, polymers with acid anhydride functions, particularly polyethylene and polypropylene provided with unsaturated acid anhydrides, polymers and copolymerisates which contain hydroxyl groups, particularly polyvinylalcohols, polyvinylalcohols containing ethylene and hydroxyethylacrylate and/or ionomers.

17. Method according to claim 15 or 16, **characterised in that** ethylene vinylacetate copolymers are provided as adhesive agent (5), wherein the copolymer parts are preferably greater than 5%.

18. Method according to any one of claims 11 to 17, **characterised in that** the carrier layer (2) before the stretching has a thickness between 5 and 3,000 microns, particularly between 10 and 500 microns, preferably between 10 and 200 microns.

19. Method according to any one of claims 11 to 18, **characterised in that** the cover layer (4) before the stretching has a thickness between 5 and 3,000 microns, particularly between 10 and 500 microns, preferably between 10 and 200 microns.

20. Thin extruded silicon layer produced in accordance with a method according to any one of claims 1 to 19.

21. Thin silicon layer according to claim 20, **characterised in that** the silicon layer (3) consisting of the thermoplastic silicon elastomer has a thickness of 0.1 to 3,000 microns, preferably 1 to 70, particularly between 1 to 30 microns, with particular preference between 5 and 20 microns.

22. Thin silicon layer according to claim 20 or 21, **characterised in that** the thermoplastic silicon elastomer preferably has a proportion of organic silicon components which is greater than 90%.

23. Thin silicon layer according to claim 20, 21 or 22, **characterised in that** the silicon elastomer has a separating force relative to adhesives, particularly relative to pressure-sensitive adhesives, of between 1 and 700 cN/cm, preferably between 5 and 100 cN/cm.

24. Thin silicon layer according to any one of claims 20 to 23, **characterised in that** the silicon elastomer has a melt viscosity between 10,000 and 100,000, particularly between 35,000 and 45,000, Pas.

25. Thin silicon layer according to any one of claims 20 to 24, **characterised in that** the silicon elastomer has a Shore hardness between 10 and 100, particularly between 50 and 60.

26. Thin silicon layer according to any one of claims 20 to 25, **characterised in that** the adhesive force reduction according to FINAT 11 of a pressure-sensitive adhesive due to the silicon elastomer is less than 30%, particularly less than 10%.

27. Thin silicon layer according to any one of claims 20 to 26, **characterised in that** the thickness of the silicon elastomer layer (3) after the stretching is between 0.1 and 400 microns, particularly between 0.1 and 50 microns, preferably between 0.1 and 5 microns.

28. Use of a thin extruded thermoplastic silicon elastomer in the form of a silicon layer according to any one of claims 20 to 27, produced in accordance with a method according to any one of claims 1 to 19, **characterised in that** a composite of silicon layer (3) and cover layer (4) and/or carrier layer (2) is used for producing, covering or lining an article to be provided with a silicon layer (3), particularly a wrapping or a vessel (6).

29. Use according to claim 28, **characterised in that** the silicon layer (3) is laminated on a base material, wherein the carrier layer (2) or cover layer (4) faces away from the base material and is then deep-drawn together with the base material to form a container (6).

30. Use according to claim 28, **characterised in that** the composite (1) of carrier layer (2), silicon layer (3) and cover layer (4) is applied in common to a base material and then deep-drawn together with the base material to form a container (6).

31. Use according to claim 28, **characterised in that** the composite (1) of carrier layer (2), silicon layer (3) and cover layer (4) is deep-drawn in common to form a container (6).

32. Use according to claim 29, 30 or 31, **characterised in that** the carrier layer (2) or the cover layer (4) is pulled off after completion of the container (6).

33. Use according to any one of claims 28 to 32, **characterised in that** the silicon layer (3) forms a highly transparent, preferably weather-stable protective layer for the article.

34. Use according to any one of claims 28 to 33, **characterised in that** the silicon layer (3) forms a dirt-repelling protective layer for the article.

35. Use according to any one of claims 28 to 34, **characterised in that** the silicon layer (3) is used as a protective layer in particular on particularly smooth surfaces.

36. Use according to claim 35, **characterised in that** the silicon layer (3) is held on, in particular, smooth surfaces by adhesion.

37. Use according to any one of claims 28 to 36, **characterised in that** the silicon layer (3) is used as a separating layer with respect to any areal objects.

38. Use according to any one of claims 28 to 37, **characterised in that** the silicon layer (3) finds use in sanitary applications, particularly in sanitary wrappings or the like.

39. Use according to any one of claims 28 to 38, **characterised in that** the silicon layer (3) is used as an intermediate layer between several plies of a window pane.

40. Use according to any one of claims 28 to 39, **characterised in that** the silicon layer (3) is produced connected with several layers and together with these layers forms a window pane or the like.

## Revendications

1. Procédé de fabrication de couches minces d'un silicone extrudable, **caractérisé en ce qu'**une couche de silicone (3) est réunie au moins avec une couche de support (2), une couche de recouvrement (4) pouvant être disposée du côté de la couche de silicone (3) opposé à la couche de support (2) et au moins la couche de silicone (3) composée d'un élastomère de silicone thermoplastique étant extrudée sur la couche de support (2) ou au moins la couche de silicone (3) et la couche de support (2) étant extrudées ensemble à travers une buse d'extrusion, et qu'au moins le composite formé de la couche de support (2) et de la couche de silicone (3) est étiré et qu'au moins la couche de support (2) ou la couche de recouvrement (4) est retirée après l'étirage.

2. Procédé selon la revendication 1, **caractérisé en ce que** la couche de silicone (3) est extrudée en même temps que la couche de recouvrement (4) sur la couche de support (2).

3. Procédé selon la revendication 1 ou 2, **caractérisé en ce qu'**un agent adhésif (5) est introduit entre la couche de support (2) et la couche de silicone (3).

4. Procédé selon la revendication 1, 2 ou 3, **caractérisé en ce qu'**un agent adhésif (5) est introduit entre la couche de recouvrement (4) et la couche de silicone (3).

5. Procédé selon la revendication 3 ou 4, **caractérisé en ce que** l'agent adhésif (5) est extrudé en même temps que la couche de silicone (3).

6. Procédé selon la revendication 3 ou 4, **caractérisé en ce que** l'agent adhésif (5) est extrudé en même temps que la couche de recouvrement (4) ou la couche de support (2).

7. Procédé selon la revendication 3 ou 4, **caractérisé en ce que** l'agent adhésif (5) est appliqué sur la couche de silicone (3) déjà extrudée.

8. Procédé selon la revendication 3 ou 4, **caractérisé en ce que** l'agent adhésif (5) est appliqué sur la couche de recouvrement (4) ou la couche de support (2) déjà extrudée.

9. Procédé selon une des revendications précédentes, **caractérisé en ce que** la couche de silicone (3) finie est enroulée.

10. Procédé selon la revendication 9, **caractérisé en ce qu'**une couche de recouvrement (4) ou de support (2) est prévue entre deux plis de la couche de silicone (3).

11. Procédé selon une des revendications précédentes, **caractérisé en ce qu'**un matériau thermoplastique est prévu comme couche de support (2) et/ou couche de recouvrement (4).

12. Procédé selon la revendication 11, **caractérisé en ce que** du polyéthylène, en particulier du LDPE ou du LLDPE, est prévu comme matériau thermoplastique.

13. Procédé selon la revendication 11 ou 12, **caractérisé en ce que** du polypropylène, en particulier des homopolymères de polypropylène et des copolymères de polypropylène, est prévu comme matériau thermoplastique.

14. Procédé selon une des revendications 11 à 13, **caractérisé en ce qu'**un mélange de différents matériaux est prévu comme couche de support (2) et/ou couche de recouvrement (4).

15. Procédé selon une des revendications 11 à 14, **caractérisé en ce que** l'on utilise comme agents adhésifs (5) des copolymères éthylène/acrylate, des copolymères éthylène/vinylacétate, des copolymères d'acides, des polymères avec des fonctions anhydride d'acide, en particulier du polyéthylène et du polypropylène pourvus d'anhydrides d'acide insaturés, des polymères et des copolymérisats contenant des groupes hydroxyle, en particulier des alcools polyvinyliques, des alcools polyvinyliques contenant de l'éthylène, de l'acrylate d'hydroxyéthyle ou des ionomères.

16. Procédé selon la revendication 15, **caractérisé en ce que** les agents adhésifs (5) sont composés de mélanges ou de lots qui contiennent au moins en partie des copolymères éthylène/acrylate, des copolymères éthylène/vinylacétate, des copolymères d'acides, des polymères avec des fonctions anhydride d'acide, en particulier du polyéthylène et du polypropylène pourvus d'anhydrides d'acide insaturés, des polymères et des copolymérisats contenant des groupes hydroxyle, en particulier des alcools polyvinyliques, des alcools polyvinyliques contenant de l'éthylène, de l'acrylate d'hydroxyéthyle et/ou des ionomères.

17. Procédé selon la revendication 15 ou 16, **caractérisé en ce que** des copolymères éthylène/vinylacétate sont prévus comme agents adhésifs (5), les proportions de copolymères étant de préférence supérieures à 5 %.

18. Procédé selon une des revendications 11 à 17, **caractérisé en ce que** la couche de support (2) présente avant l'étirage une épaisseur comprise entre 5 et 3000 µm, en particulier entre 10 et 500 µm, de préférence entre 10 et 200 µm.

19. Procédé selon une des revendications 11 à 18, **caractérisé en ce que** la couche de recouvrement (4) présente avant l'étirage une épaisseur comprise entre 5 et 3000 µm, en particulier entre 10 et 500 µm, de préférence entre 10 et 200 µm.

20. Couche mince de silicone extrudée fabriquée d'après le procédé selon les revendications 1 à 19.

21. Couche mince de silicone selon la revendication 20, **caractérisée en ce que** la couche de silicone (3) en élastomère de silicone thermoplastique présente une épaisseur comprise entre 0,1 et 3000 µm, de préférence entre 1 et 70 µm, particulièrement entre 1 et 30 µm, tout particulièrement entre 5 et 20 µm.

22. Couche mince de silicone selon la revendication 20 ou 21, **caractérisée en ce que** l'élastomère de silicone thermoplastique présente de préférence une proportion d'une composante de silicone organique qui est supérieure à 90 %.

23. Couche mince de silicone selon la revendication 20, 21 ou 22, **caractérisée en ce que** l'élastomère de silicone présente une force de séparation par rapport aux adhésifs, en particulier par rapport aux adhésifs autocollants, comprise entre 1 et 700 cN/cm, de préférence entre 5 et 100 cN/cm.

24. Couche mince de silicone selon une des revendications 20 à 23, **caractérisée en ce que** l'élastomère de silicone présente une viscosité à l'état fondu comprise entre 10000 et 100000, en particulier entre 35000 et 45000 Pas.

25. Couche mince de silicone selon une des revendications 20 à 24, **caractérisée en ce que** l'élastomère de silicone présente une dureté Shore comprise entre 10 et 100, en particulier entre 50 et 60.

26. Couche mince de silicone selon une des revendications 20 à 25, **caractérisée en ce que** la diminution du pouvoir adhésif selon FINAT 11 d'un adhésif autocollant par l'élastomère de silicone est < 30 %, en particulier < 10 %.

27. Couche mince de silicone selon une des revendications 20 à 26, **caractérisée en ce que** l'épaisseur de la couche d'élastomère de silicone (3) après l'étirage est comprise entre 0,1 et 400 µm, en particulier entre 0,1 et 50 µm, de préférence entre 0,1 et 5 µm.

28. Utilisation d'un élastomère de silicone thermoplastique mince extrudé sous la forme d'une couche de silicone selon une des revendications 20 à 27, fabriquée d'après un procédé selon une des revendications 1 à 19, **caractérisée en ce qu'**un composite formé d'une couche de silicone (3) et d'une couche de recouvrement (4) et/ou d'une couche de support (2) est utilisé pour fabriquer, recouvrir ou garnir un objet à munir d'une couche de silicone (3), en particulier un emballage ou un récipient (6).

29. Utilisation selon la revendication 28, **caractérisée en ce que** la couche de silicone (3) est contrecollée sur un matériau de base, la couche de support (2) ou de recouvrement (4) s'éloignant du matériau de base, et ensuite emboutie en même temps que le matériau de base pour former un récipient (6).

30. Utilisation selon la revendication 28, **caractérisée en ce que** le composite (1) formé de la couche de support (2), de la couche de silicone (3) et de la couche de recouvrement (4) est appliqué ensemble sur un matériau de base et ensuite embouti en même temps que le matériau de base pour former un récipient (6).

31. Utilisation selon la revendication 28, **caractérisée en ce que** le composite (1) formé de la couche de support (2), de la couche de silicone (3) et de la couche de recouvrement (4) est embouti ensemble pour former un récipient (6).

32. Utilisation selon la revendication 29, 30 ou 31, **caractérisée en ce que** la couche de support (2) ou la couche de recouvrement (4) est retirée après achèvement du récipient (6).

33. Utilisation selon une des revendications 28 à 32, **caractérisée en ce que** la couche de silicone (3) forme une couche protectrice hautement transparente, de préférence résistante aux intempéries, pour l'objet.

34. Utilisation selon une des revendications 28 à 33, **caractérisée en ce que** la couche de silicone (3) forme une couche protectrice anti-salissante pour l'objet.

35. Utilisation selon une des revendications 28 à 34, **caractérisée en ce que** la couche de silicone (3) est utilisée comme couche protectrice sur des surfaces notamment lisses.

36. Utilisation selon la revendication 35, **caractérisée en ce que** la couche de silicone (3) est retenue par adhérence sur des surfaces notamment lisses.

37. Utilisation selon une des revendications 28 à 36, **caractérisée en ce que** la couche de silicone (3) est utilisée comme couche de séparation par rapport à des structures planes quelconques.

38. Utilisation selon une des revendications 28 à 37, **caractérisée en ce que** la couche de silicone (3) est utilisée dans des applications d'hygiène, en particulier dans des emballages hygiéniques ou analogues.

39. Utilisation selon une des revendications 28 à 38, **caractérisée en ce que** la couche de silicone (3) est utilisée comme couche intermédiaire entre plusieurs couches d'une vitre.

40. Utilisation selon une des revendications 28 à 39, **caractérisée en ce que** la couche de silicone (3) est fabriquée en combinaison ou en liaison avec d'autres couches et forme une vitre ou analogue avec ces couches.
